# EUROPÄISCHE PATENTSCHRIFT

(11) **EP 0 871 130 B1**
(45) Veröffentlichungstag und Bekanntmachung des Hinweises auf die Patenterteilung: **10.09.2003**
(21) Anmeldenummer: 98106434.8
(22) Anmeldetag: 08.04.1998
(51) Int. Cl.: H05K 7/14

(54) **Busfähige elektrische Koppeleinheit**
Electrical coupling unit with bus interface
Unité de couplage électrique avec interface de bus

(30) Priorität: 10.04.1997 DE 19714868
(43) Veröffentlichungstag der Anmeldung: 14.10.1998
(73) Patentinhaber: Moeller GmbH, 53115 Bonn (DE)
(72) Erfinder: Boldin, Rudi, 52372 Kreuzau (DE); Wey, Paul, 53340 Meckenheim (DE); Müsseler, Willi, 53347 Alfter-Oedekoven (DE)

(56) Entgegenhaltungen:
- DE-A- 4 437 316
- DE-C- 4 438 805
- DE-U- 29 607 525

## Beschreibung

Die Erfindung betrifft eine busfähige elektrische Koppeleinheit nach dem Oberbegriff des Anspruches 1.

Eine nach der Druckschrift DE 296 10 157 U1 bekannte Koppeleinheit besteht aus einem Gehäuse, das einen Busanschluß für eine mit einem Master verbundene Busleitung, eine vierfache elektrische Schnittstelle für anzusteuernde und/oder ansteuernde elektrische Einrichtungen sowie eine elektronische Baugruppe zur Organisation des Datenaustausches zwischen dem Bus und den elektrischen Einrichtungen besteht. Eine konstruktive Ausführung einer derartigen Koppeleinheit ist in der Druckschrift DE 93 05 529 U1 zu erkennen. Diese bekannten Koppeleinheiten sind als Buskoppler für die Ankopplung von elektrischen Einrichtungen an den Aktor-Sensor-Interface (ASI) als Bussystem vorgesehen.

Die Druckschrift DE 44 38 805 zeigt ein Feldbusanschlußmodul, das durch Austausch der Elektronik an verschiedene Feldbussysteme anpaßbar ist.

Nun gibt es eine Vielzahl von Bussystemen, die anbieterseitig, regional bzw. kontinental unterschiedlich ausgeprägt sind. Neben unterschiedlichen Protokollen zum Datenaustausch sind systemabhängig unterschiedliche Netztopologien mit unterschiedlichen Teilnehmerzahlen realisierbar. Eine starke Differenzierung liegt bei den realisierbaren Zykluszeiten vor. Alle Bussysteme bieten Stärken und Schwächen in unterschiedlicher Ausprägung. Deshalb ist zur Zeit eine Bereinigung des Sortiments an Bussystemen über ihre Merkmale und Vorteile nicht zu erwarten. Ein Bussystem, das alle Anforderungsprofile der Anwender universell abdeckt, ist nicht bekannt.

Von allgemeinem Nachteil bei bekannten busfähigen Koppeleinheiten ist, daß sie ausschließlich für die Ankopplung an ein jeweils spezielles Bussystem vorgesehen sind. Die Anpassung der mit dem jeweiligen Bussystem zu koppelnden elektrischen Einrichtungen, beispielsweise Schaltgeräten, muß über eine Koppeleinheit erfolgen, die sowohl software- als auch hardwaremäßig mit dem Bussystem kompatibel ist. Die Kompatibilität hinsichtlich der Software betrifft insbesondere die Organisation des Datenaustausches zwischen Master und Slave sowie die Datencodierung. Die Kompatibilität hinsichtlich der Hardware betrifft insbesondere die Anschlußtechnik sowie die Versorgungspotentiale und Steuersignalpegel.

Der Druckschrift DE 38 08 364 A1 ist eine Steckkarte mit zwei verschiedenen Steckkontaktbaugruppen als Busanschlüsse zu entnehmen. Die Steckkarte enthält hinsichtlich verschiedener Bussysteme mehrfach-kompatible elektronische Baugruppen, welche den einen oder anderen, mit jeweils einem unterschiedlichen Bussystem untrennbar verbundenen Personalcomputer hinsichtlich einer Zusatzleistung unterstützen können. Aus der Druckschrift EP 0 591 657 A1 ist eine steckbare Adapterplatte bekannt,die für zwei, mit unterschiedlichen Bussystemen ausgestattete Computersystemen verwendbar ist, wobei die Adapterkarte über seinen ersten bzw. zweiten Busanschluß mit einem ersten bzw. zweiten Bussystem eines ersten bzw. zweiten Computersystems sowie mit einem weiteren Steckverbinder über Schnittstellenanschlüsse einer Befestigungskarte mit peripheren elektrischen Einrichtungen zu verbinden ist, was dazu dient, das jeweils vorhandene Bussystem zur Kommunikation mit der betreffenden elektrischen Einrichtung zu befähigen, wozu elektronische Baugruppen auf der Adapterplatte für mehrere Bussysteme aufgebracht sind. Diese beiden Druckschriften geben keinen Hinweis darüber, wie eine Mehrzahl von unverändert belassenen, insbesondere vorinstallierten elektrischen Einrichtungen vor Ort an ein beliebiges Bussystem angepaßt werden kann.

Der Erfindung liegt daher die Aufgabe zugrunde, unverändert belassene elektrische Einrichtungen, insbesondere vorinstallierte Schaltgerätekombinationen, vor Ort in wirtschaftlicher Weise an ein beliebiges der verschiedenen Bussysteme zu koppeln.

Ausgehend von einer busfähigen elektrischen Koppeleinheit der eingangs genannten Art wird die Aufgabe erfindungsgemäß durch die kennzeichnenden Merkmale der unabhängigen Ansprüche gelöst, während den Unteransprüchen vorteilhafte Weiterbildungen der Erfindung zu entnehmen sind.

Einerseits wird bei verschiedenen und damit zu mehreren Bussystemen passend installierten Busanschlüssen durch das Einsetzen eines entsprechenden Verarbeitungsmoduls in einfacher Weise die Koppeleinheit für ein bestimmtes von mehreren Bussystemen zugerüstet. Die verschiedenen Busanschlüsse können fest installiert sein. Es ist aber auch mit Vorteil möglich, für mindestens einen der Busanschlüsse austauschbare Busanschlüsse vorzusehen.

Anderseits wird durch das Einsetzen eines entsprechenden Verarbeitungsmoduls sowie der erforderlichen Anzahl entsprechender Anschlußmodule in einfacher Weise die Koppeleinheit für ein bestimmtes von vielen Bussystemen zugerüstet.

Die so zugerüstete und mit den anzusteuernden bzw. ansteuernden elektrischen Einrichtungen steuerseitig zu verbindenden Koppeleinheit gewährt damit die volle Kompatibilität hinsichtlich der Datenverarbeitung, der Signalpegel, der Versorgungspotentiale und der Anschlußtechnik mit einem beliebig auszuwählenden Bussystem aus einer Vielzahl möglicher Bussysteme. Der Vorteil dieser Lösungen besteht vor allem darin, daß anzusteuernde bzw. ansteuernde elektrische Einrichtungen, insbesondere Schaltgeräte, unabhängig vom auszuwählenden Bussystem zu Kombinationen zusammengestellt sowie vorinstalliert werden können und daß durch Verbindung mit einer Koppeleinheit, die auf das vom Kunden beliebig auszuwählende Bussystem zugerüstet worden ist, die Kompatibilität der Kombination mit diesem Bussystem in jedem Falle hergestellt wird. Die Zurüstung der Koppeleinheit erfolgt vorteilhafterweise beim Hersteller nach Kundenangaben. Durch die Erfindung sind elektrische Einrichtungen sowie deren vorinstallierte Kombinationen "offen" für eine Vielzahl von Bussystemen, d.h., sie sind mit den verschiedensten Bussystemen wirtschaftlich vernetzbar. Es können elektrische Einrichtungen sowie Kombinationen von elektrischen Einrichtungen busunabhängig und Buskoppler modular mit hohen Stückzahlen hergestellt und damit billig angeboten werden. Die Erfindung ermöglicht weiterhin die volle Ausnutzung der einzusetzenden busspezifischen Baugruppen zur Organisation des Datenaustausches zu und von den anzusteuernden bzw. ansteuernden elektrischen Einrichtungen.

Für die Erfindung ist es unerheblich, ob gemeinsame oder getrennte Busleitungen für Daten, Steuersignale und Versorgungspotentiale zu verwenden sind. Die Busanschlüsse bzw. Anschlußmodule der Koppeleinheiten können mit Vorteil sowohl durch an sich bekannte elektrische Abgriffe für durchgehende Busleitungen als auch durch Doppelausführung für über die Koppeleinheiten hintereinander zu verbindende Busleitungen ausgebildet werden. Um zu verhindern, daß unzulässige Versorgungspotentiale in die Koppeleinheit eingeleitet werden, sind die verschiedenen Busanschlüsse bzw. Anschlußmodule bei einer Weiterbildung in der Art codiert, daß bei sonstiger Übereinstimmung, d.h. der gegebenenfalls verwechslungsfähigen Anschlußtechnik verschiedener Bussysteme, keine Fehlverbindung durchführbar ist.

Besonders vorteilhaft ist es, wenn für die jeweiligen Bussysteme Verarbeitungs-Anschlußmodule vorgesehen sind. Jedes dieser Verarbeitungs-Anschlußmodule vereinigt in sich das zu dem jeweiligen Bussystem kompatible Verarbeitungsmodul mit dem bzw. den kompatiblen Anschlußmodul bzw. Anschlußmodulen.

Vorteilhafte Weiterbildungen bestehen weiterhin darin, daß die elektronische Baugruppe bzw. das Verarbeitungsmodul oder das Verarbeitungs-Anschlußmodul in Verbindung mit trennbaren elektrischen Verbindungselementen von einem Träger oder/und von einer Leiterplatte aufgenommen wird. Der Träger ist zweckmäßigerweise an bzw. in das Gehäuse der Koppeleinheit aufzurasten oder/und festzuschrauben. Eine andere vorteilhafte Weiterbildung besteht darin, daß das Verarbeitungsmodul bzw. Verarbeitungs-Anschlußmodul von einem mit dem Gehäuse zu verbindenden Deckel verschlossen wird.

Vorteilhafte Weiterbildungen der Erfindung zwecks leichter Einsetzbarkeit der Anschlußmodule bestehen darin, daß diese in oder an das Gehäuse ein- bzw. anzuschnappen oder/und mit dem Gehäuse zu verschrauben sind.

Eine weitere vorteilhafte Weiterbildung besteht in der Anordnung von leitenden Zwischenelementen, um beim Einsetzen die Module elektrisch zu verbinden.

Die Koppeleinheit kann in einfacher Weise mit den anzusteuernden und/oder ansteuernden Einrichtungen durch Herstellung der notwendigen elektrischen Verbindungen über den Schnittstellenanschluß verbunden werden. Für viele Anwendungsfälle ist es dabei von Vorteil, wenn die Koppeleinheit einen rückseitigen Schnittstellenanschluß aufweist, insbesondere dann, wenn beim Befestigen der Koppeleinheit auf einer Montageplatte der Schnittstellenanschluß mit einem Gegenanschluß für Steuerleitungen und dergleichen auf der Montageplatte unmittelbar oder mittelbar verbunden werden kann. Zur Befestigung der Koppeleinheit sind rückseitige Befestigungsmittel zum Aufschnappen auf eine Tragschiene, die beispielsweise Bestandteil einer Montageplatte sein kann, zweckmäßig, insbesondere dann, wenn der Schnittstellenanschluß mit einem Gegenanschluß an der Tragschiene für entlang dieser Tragschiene geführte Steuerleitungen und dergleichen verbindbar ist. Diese Weiterbildungen sind mit großem Vorteil da anzuwenden, wo bereits weitestgehend vormontierte und vorinstallierte Gerätekombinationen mit einem Bussystem zu verbinden sind.

Eine andere vorteilhafte Weiterbildung besteht darin, daß das Gehäuse selbst integraler Bestandteil einer auf diese Weise zu einer Montageplatte erweiterten Koppeleinheit ist. Diese Art der Koppeleinheit kann in vorteilhafter Weise mit elektrischen Verbindungsmitteln für weiterzuleitende Busleitungen, Steuersignale und dergleichen ausgestattet sein, um so auf diese Weise mehrere derartige, räumlich nebeneinander angeordnete Koppeleinheiten zusammen mit auf diesen montierten elektrischen Einrichtungen elektrisch und elektronisch zu koppeln. Zur Befestigung der elektrischen Einrichtungen sind vorderseitig auf Montageplatten angeordnete Tragschienen an sich bekannt.

Unabhängig von den vorstehend beschriebenen Weiterbildungen ist es für bestimmte Anwendungsfälle von Vorteil, wenn die Schnittstelle zu den elektrischen Einrichtungen an von außen zugänglichen Anschlußklemmen geführt ist. Als Schnittstellenanschluß können weitere austauschbare Anschlußmodule vorgesehen sein, um die Koppeleinheit auch an unterschiedliche Anschlußtechniken bezüglich der Leitungen für Steuersignale und/oder Versorgungspotentiale anpassen zu können. Für bestimmte Anwendungsfälle ist es auch von Vorteil, wenn separate Anschlußklemmen für über die oder zusätzlich zur Busleitung angelieferte Versorgungspotentiale und/oder besondere Steuersignale vorgesehen sind.

Für einzelne Anwendungsfälle, beispielsweise zum Testen vorinstallierter Gerätekombinationen, kann es zweckmäßig sein, die Koppeleinheit durch Einsatz eines einfachen Verbindungsmoduls und durch Ausnutzung bzw. Anpassung der entsprechenden Anschlußtechnik die konventionelle, d.h. die nicht über einen Bus geführte Ansteuerung zu ermöglichen. Diese spezielle Verwendung kann unter Umständen auch nur zeitweise erforderlich sein.

Die Erfindung soll nachstehend an Ausführungsbeispielen, aus denen weitere Einzelheiten und Vorteile zu ersehen sind, näher erläutert werden. In der zugehörigen Zeichnung zeigt
- Figur 1:: eine erste Ausführungsform einer erfindungsgemäßen Koppeleinheit in Kombination mit mehreren anzusteuernden und ansteuernden elektrischen Einrichtungen in auseinandergezogener perspektivischer Darstellung;
- Figur 2:: die Koppeleinheit nach Fig. 1 in auseinandergezogener perspektivischer Darstellung;
- Figur 3:: vereinfacht eine zweite Ausführungsform in auseinandergezogener perspektivischer Darstellung;
- Figur 4:: vereinfacht eine dritte Ausführungsform in perspektivischer Darstellung und
- Figur 5:: vereinfacht eine vierte Ausführungsform in perspektivischer Darstellung.

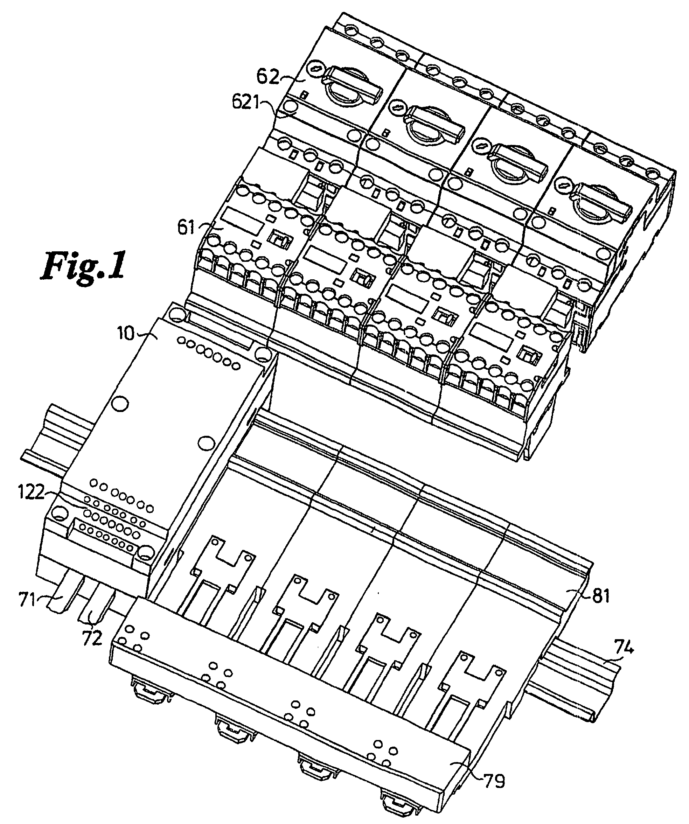

In Fig. 1 ist beispielhaft die räumliche Kombination von acht elektrischen Einrichtungen 61 und 62 mit einer busfähigen elektrischen Koppeleinheit 10 dargestellt. Die Koppeleinheit 10 ist über zwei durchgehende ASI-Busleitungen 71 und 72 mit einer nicht dargestellten Master-Einheit eines ASI-Bussystems und weiteren, ebenfalls nicht dargestellten Koppeleinheiten verbunden. Die Busleitung 71 dient zur Übertragung der Datensignale und die Busleitung 72 zur Übertragung der Versorgungspotentiale der Koppeleinheiten sowie der Aktoren der anzukoppelnden elektrischen Einrichtungen. Mit den Einrichtungen 61 und 62 werden beispielhaft vier Motorstarter für vier elektrische Motoren gebildet. Dazu werden jeweils vier Schütze 61 sowie vier Motorschutzschalter 62 verwendet. Die Magnetantriebe der Schütze 61 sind als Aktoren vom Bussystem über die Koppeleinheit 10 anzusteuern; wogegen die Motorschutzschalter 62 mittels ihrer Hilfsschalter 621, die den Schaltzustand der Motorschutzschalter 62 signalisieren, als Sensoren über die Koppeleinheit 10 auf das Bussystem steuernd einwirken. Zu jeweils einem Motor gehörige elektrische Einrichtungen 61, 62 werden paarweise elektrisch sowie mechanisch verbunden und sind auf vier seitlich verbundene Montageplatten 81 aufzuschnappen. Diese Motorstarter-Kombination kann weiterhin mit den erforderlichen Steuerleitungen (nicht dargestellt) von und zu den einzelnen elektrischen Einrichtungen 61, 62 versehen werden. Die Steuerleitungen werden einem gemeinsamen, die Montageplatten 81 übergreifenden Leitungskanal 79 zugeführt und in diesem weitergeführt. Die so vom Hersteller vormontierte und vorinstallierte Schaltgerätekombination wird zusammen mit der Koppeleinheit 10, die in noch näher zu beschreibender Weise vom Hersteller auf das von Kunden ausgewählte ASI-Bussystem zugerüstet worden ist, anschlußfertig ausgeliefert. Beim Kunden werden die vormontierte Schaltgerätekombination 61, 62, 79, 81 und die Koppeleinheit 10 auf eine gemeinsame Tragschiene 74 einer elektrischen Anlage aufgeschnappt und über die Leistungsanschlüsse der Einrichtungen 61, 62 mit den Hauptstromleitungen der elektrischen Anlage verbunden. Die Koppeleinheit wird anschließend einerseits über ihren Schnittstellenanschluß 122 mit den Steuerleitungen und anderseits mit den Busleitungen 71, 72 verbunden. Die zugerüstete Koppeleinheit 10 kann auch zur nachträglichen Auf- oder Umrüstung der elektrischen Anlage auf das ausgewählte Bussystem nachgeliefert werden.

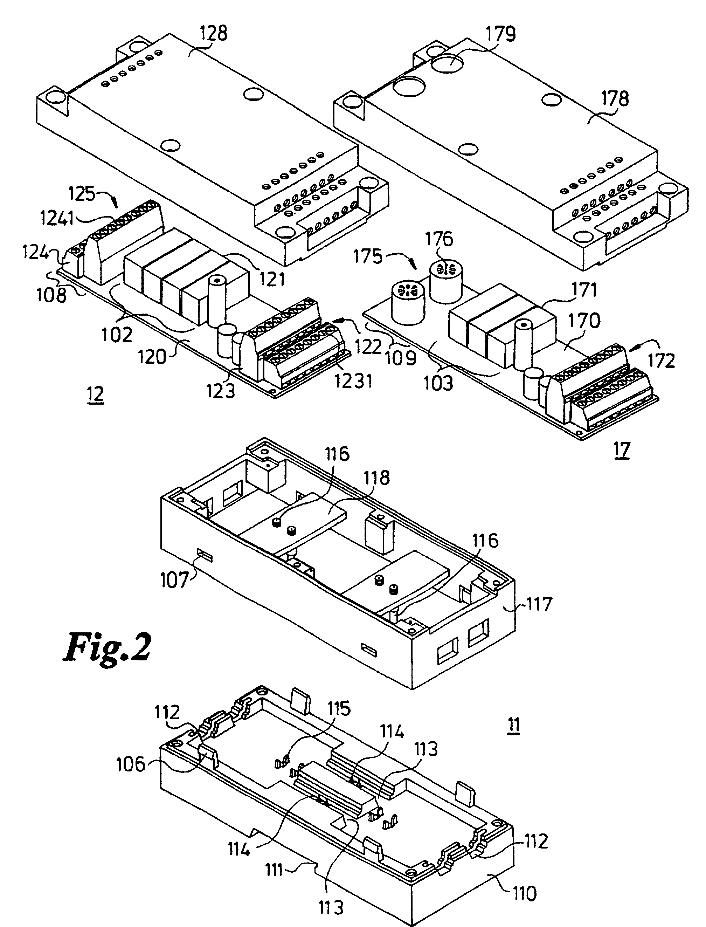

Die Koppeleinheit 10 beinhaltet nach Fig. 2 ein Gehäuse 11 sowie ein Verarbeitungs-Anschlußmodul 12. Das Gehäuse 11 ist ein Basisteil 110 mit einem Träger 117. Das Basisteil 110 besitzt rückseitige Befestigungsmittel 111 zum Aufrasten auf eine Tragschiene. Im Basisteil 110 sind Ausnehmungen 112, 113 zum Einlegen der Busleitungen und zwei abgreifende Busanschlüsse 114, welche die Isolation der Busleitungen durchdringende Kontaktspitzen aufweisen, vorgesehen. Im Basisteil 110 sind vier streifenförmige leitende Zwischenelemente 115 gelagert, die sowohl mit den Busanschlüssen 114 in Verbindung stehen als auch beim rastenden Aufsetzen des Trägers 117 mit in zwei Querstegen 118 des Trägers 117 gelagerten, vier messerkontaktartigen elektrischen Zwischenelementen 116 verbunden werden. Rastende Mittel 106, 107 an der Basiseinheit 110 bzw. am Träger 117 dienen zum formschlüssigen Zusammensetzen des Gehäuses 11. Das Verarbeitungs-Anschlußmodul 12 besteht aus einer bestückten Leiterplatte 120 und einem Deckel 128. Auf der Leiterplatte 120 sind eine elektronische Baugruppe 121 aus mehreren Schaltkreisen, der bereits erwähnte elektrische Schnittstellenanschluß 122, ein weiterer Busanschluß 125 sowie die elektrischen Verbindungen zwischen diesen Elementen vorgesehen. Die elektronische Baugruppe 121 organisiert den Datenaustausch zwischen dem Bussystem und den anzusteuernden bzw. ansteuernden elektrischen Einrichtungen 61, 62 (Fig. 1). Der elektrische Schnittstellenanschluß 122 besteht aus zwei Klemmenleisten 123 mit mehreren Anschlußklemmen 1231 zum Anschließen der Steuerleitungen. Beim Einsetzen der Leiterplatte 120 in den Träger 117 und Festlegung der Leiterplatte 120 durch Festschrauben des aufzusetzenden Deckels 128 auf das Gehäuse 11 wird das Verarbeitungs-Anschlußmodul 12 mit dem Gehäuse 11 zu der Koppeleinheit 10 vervollständigt; dabei wird ebenso die elektrische Verbindung zwischen dem Busanschluß 114 und dem Verarbeitungs-Anschlußmodul 12 durch Herstellen der elektrischen Kontaktverbindung zwischen den messerkontaktartigen Zwischenelementen 116 und rückseitig an der Leiterplatte 120 vorgesehenen elektrischen Verbindungselementen hergestellt. Der weitere Busanschluß 125 besteht aus zwei weiteren Klemmleisten 124. Der weitere Busanschluß 125 kann zum einen dazu dienen, daß über ihn die Koppeleinheit 10 alternativ über anzuschließende konventionelle Drahtleitungen mit dem ASI-Bussystem oder anderseits über ebensolche Drahtleitungen mit einem andersartige Bussystem verbindbar ist, wobei die elektronische Baugruppe 121 im ersteren Fall mit dem ASI-Bussystem und im letzteren Fall mit dem andersartigen Bussystem kompatibel sein muß. In beiden Fällen sind einzelne Anschlußklemmen 1241 des Busanschlusses 125 doppelt belegt und paarweise verbunden, um so ankommende und abgehende Busleitungen über die Koppeleinheit 10 zu verbinden. Einzelne Anschlußklemmen 1241 des Busanschlusses 125 können im übrigen auch zum Anlegen separater Leitungen für Versorgungspotentiale und/oder besonderer Steuersignale vorgesehen sein.

Um die Kompatibilität zu weiteren Bussysteme herzustellen, stehen weitere Verarbeitungs-Anschlußmodule zur Verfügung, mit denen die Koppeleinheit 10 alternativ zu bestücken ist. In Fig. 2 ist beispielhaft ein weiteres Verarbeitungs-Anschlußmodul 17 dargestellt, mit dem die Kompatibilität des Koppelmoduls 10 alternativ zum ASI-Bussystem mit einem andersartigen Bussystem herstellbar ist. Das Verarbeitungs-Anschlußmodul 17 besteht ebenfalls aus einer bestückten Leiterplatte 170 und einem zugehörigen Deckel 178. Die Leiterplatte 170 ist mit einer elektronischen Baugruppe 171 zur Organisation des Datenaustausches mit dem andersartigen Bussystem, einem Schnittstellenanschluß 172 und einem mit dem Bussystem anschlußtechnisch kompatiblen weiteren Busanschluß 175 aus zwei elektrisch parallel verbundenen Steckanschlüssen 176 für die durchgehende Verbindung ankommender und abgehender steckbarer, geschirmter Busleitungen bestückt. Für die Steckanschlüsse 176 sind im Deckel 178 entsprechende Durchbrüche 179 vorgesehen.

Die elektronischen Baugruppen 121 und 171 bilden im wesentlichen Verarbeitungsmodule 102 und 103. Die weiteren Busanschlüsse 125 und 175 sind als Anschlußmodule 108 und 109 anzusehen. Jeweils ein Verarbeitungsmodul 102 bzw. 103 sowie jeweils ein Anschlußmodul 108 bzw. 109 sind als wesentliche Bestandteile in dem Verarbeitungs-Anschlußmodul 12 bzw. 17 vereinigt.

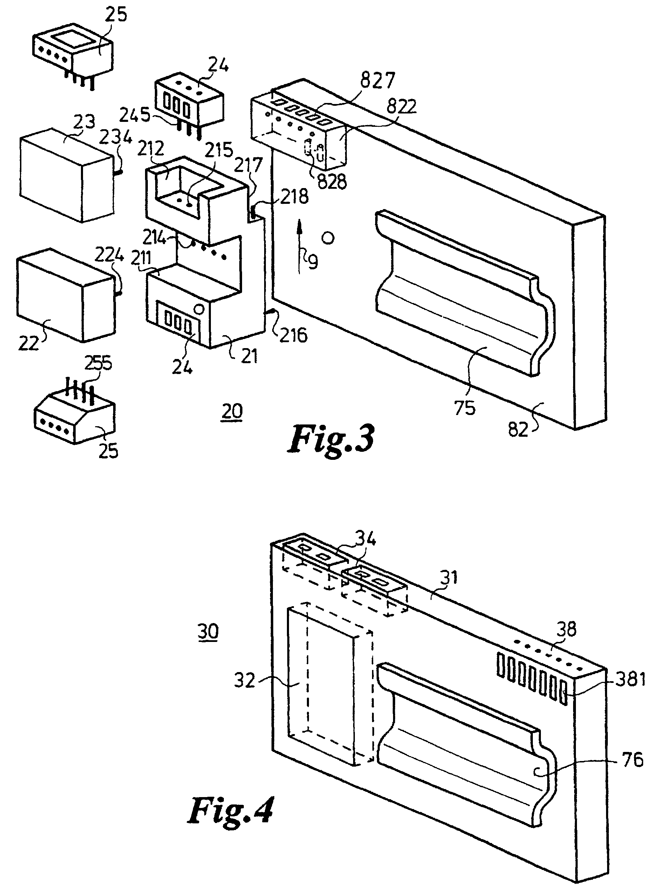

In Fig. 3 ist eine weitere Koppeleinheit 20 dargestellt. Grundteil der Koppeleinheit ist das Gehäuse 21. Im dem Gehäuse 21 ist eine ersten Aussparung 211 vorgesehen, in die wahlweise eines von mehreren Verarbeitungsmodulen mittels rastender Mittel einzusetzen ist. Von diesen Verarbeitungsmodulen sind beispielhaft zwei Verarbeitungsmodule 22 und 23 dargestellt, welche den kompatiblen Datenaustausch mit unterschiedlichen Bussystemen gewährleisten. Beim Einsetzen eines der Verarbeitungsmodule 22, 23 in die erste Aussparung 211 werden die elektrischen Verbindungen zwischen rückseitigen ersten Verbindungselementen 224 bzw. 234 in Form von Verbindungsstiften der Verarbeitungsmodule 22 bzw. 23 und entsprechenden ersten Aufnahmebuchsen 214 am Grunde der ersten Aussparung 211 hergestellt. Oberhalb und unterhalb der ersten Aussparung 211 ist im Gehäuse 21 jeweils eine zweite Aussparung 212 vorgesehen, in die wahlweise eines von mehreren Anschlußmodulen mittels rastender Mittel einzusetzen ist. Von diesen Anschlußmodulen sind beispielhaft jeweils zwei gleichen Anschlußmodule 24 bzw. 25 dargestellt, welche die kompatible Anschlußtechnik mit den unterschiedlichen Bussystemen gewährleisten. Beim Einsetzen der beiden gleichen Anschlußmodule 24 oder 25 in die zweiten Aussparungen 212 werden die elektrischen Verbindungen zwischen zweiten Verbindungselementen 245 bzw. 255 in Form von Verbindungsstiften der Anschlußmodule 24 bzw. 25 und entsprechenden zweiten Aufnahmebuchsen 215 in den zweiten Aussparungen 212 hergestellt. Das untere der Anschlußmodule 24 ist im bereits eingesetzten Zustand dargestellt. Innerhalb des Gehäuses 21 sind leitende, jedoch nicht sichtbare Zwischenelemente zwischen den Aufnahmebuchsen 214 und 215 angeordnet. Beispielhaft sind die Anschlußmodule 24 mit Schraubklemmen und die Anschlußmodule 25 mit Zugfederklemmen ausgestattet; jedoch sind Anschlußmodule keineswegs auf diese Anschlußtechniken beschränkt. In das Gehäuse 21 ist das Verarbeitungsmodul 22 zusammen mit den zugehörigen Anschlußmodulen 24 oder das Verarbeitungsmodul 23 zusammen mit den zugehörigen Anschlußmodulen 25 einzusetzen. Durch Übereinstimmung der wesentlichen äußeren Abmessungen der Bearbeitungsmodule bzw. der Anschlußmodule ist die Modularität dieser Module gewährleistet.

Das Gehäuse 21 ist im oberen Bereich seiner Rückseite 216 mit einer zurücktretenden Abstufung 217 ausgebildet. Die Abstufung 217 ist mit einem mehrpoligen, nach oben weisenden stiftartigen Schnittstellenanschluß 218 versehen. In Fig. 3 ist weiterhin eine Montageplatte 82 mit einer Tragschiene 75 zur Befestigung anzusteuernder und/oder ansteuernder elektrischer Einrichtungen, die mit der Koppeleinheit 20 zu verbinden sind, dargestellt. Auf der Montageplatte 82 ist weiterhin eine Anschlußleiste 822 befestigt, die einerseits mit Anschlußklemmen 827 für anzuschließende Steuerleitungen zu bzw. von den anzusteuernden bzw. ansteuernden elektrischen Einrichtungen und anderseits mit einem angedeuteten mehrpoligen, nach unten weisenden buchsenartigen Gegenanschluß 828 für den Schnittstellenanschluß 218 ausgestattet ist. Nach dem Aufsetzen der Koppeleinheit 20 auf die Montageplatte 82, auf der vorteilhafterweise die elektrischen Einrichtungen bereits montiert und weitestgehend elektrisch installiert sind, wird die Koppeleinheit 20 in Pfeilrichtung 9 nach oben verschoben, wodurch die elektrische Verbindung zwischen ihrem Schnittstellenanschluß 218 und dem Gegenanschluß 828 hergestellt wird. Danach ist die Koppeleinheit 20 mit der Montageplatte, beispielsweise über Schraubverbindungsmittel, mechanisch zu verbinden. Über die Anschlußmodule 24 bzw. 25 werden anzuschließende Busleitungen innerhalb des Gehäuses 21 elektrisch durchgehend verbunden.

Eine busfähige elektrische Koppeleinheit 30 nach Fig. 4 ist zu einer Montageplatte für mit dieser Koppeleinheit zu verbindende anzusteuernde und/oder ansteuernde elektrische Einrichtungen, die auf einer mit dem Gehäuse 31 verbundenen Tragschiene 76 zu montieren sind, erweitert worden. In dem Gehäuse 31 sind entsprechende vorderseitige und oberseitige Aussparungen vorgesehen, in welche ein Verarbeitungsmodul 32 aus einer Gruppe unterschiedlicher Verarbeitungsmodule und ein Paar Anschlußmodule 34 aus einer Gruppe unterschiedlicher Anschlußmodule einzusetzen sind. Durch die Auswahl eines entsprechenden Verarbeitungsmoduls mit einem zugehörigen Paar Anschlußmodule wird auch hier die volle Kompatibilität der Koppeleinheit mit einem ausgewählten Bussystem hergestellt. Die Schnittstelle zu den anzukoppelnden elektrischen Einrichtungen ist am Gehäuse 31 oberseitig als Schnittstellenanschluß 38 mit einer Reihe von Anschlußklemmen 381 herausgeführt. Innerhalb des Gehäuses 31 sind in nicht sichtbarer Weise elektrisch leitende Zwischenelemente angeordnet, welche die erforderlichen Verbindungen zwischen Verarbeitungsmodul 32, Anschlußmodulen 34 und Schnittstellenanschluß 38 herstellen. Durch den paarweisen Einsatz von Anschlußmodulen 34, die innerhalb des Gehäuses 31 durchgehend verbunden sind, wird die durchgängige Verbindung von zu- und abgehenden Busleitungen geschaffen. Sollen durchgehende Busleitungen, beispielsweise ASI-Busleitungen, zur Anwendung kommen, dann sind die Anschlußmodule 34 mit entsprechende abgreifenden Kontakten auszustatten. Sollte nur eine durchgehende Busleitung anzuschließen sein, dann kann zweckmäßigerweise eines der beiden Anschlußmodule 34 als Blindelement ausgebildet sein.

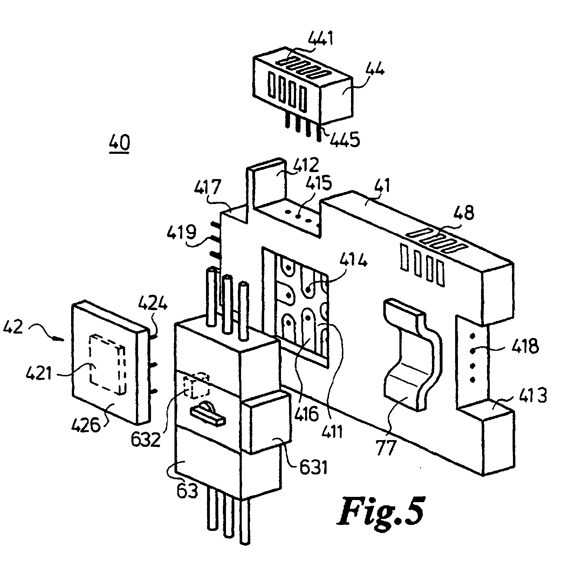

Fig. 5 zeigt eine weitere Koppeleinheit 40, deren Gehäuse 41 ebenfalls zu einer Montageplatte weitergebildet worden ist. Die Verarbeitungsmodule 42 bestehen aus einem in eine erste Ausnehmung 411 einzusetzenden Träger 426, in dem eine an das jeweilige Bussystem angepaßte elektronische Baugruppe 421 in Form eines Halbleiter-Chip sowie damit verbundene, nach außen ragende, stiftförmige elektrische Verbindungselemente 424 integriert sind. Die ebenfalls mit stiftförmigen elektrischen Verbindungselementen 445 ausgestatteten Anschlußmodule 44 sind in eine zweite Ausnehmung 412 des Gehäuses 41 einzusetzen. Zur Aufnahme der Verbindungselemente 424 und 445 sind in den Ausnehmungen 411 und 412 Aufnahmebuchsen 414 und 415 vorgesehen, die durch leitende Zwischenelemente 416 verbunden sind, die im Gehäuse 41 festgelegt sind. Auf dem Gehäuse 41 ist eine Tragschiene 77 für elektrische Einrichtungen angeordnet. In Fig. 5 ist als elektrische Einrichtung 63 beispielhaft ein Leistungsschalter mit einem ansteuernden Hilfsschalter 631 als Sensor und einem anzusteuernden Unterspannungs-Auslöser 632 als Aktor dargestellt. Die Anschlußklemmen 441 des beispielhaft gezeigten Anschlußmoduls 44 sind doppelt ausgeführt und paarweise elektrisch verbunden, um eine durchgehende elektrische Verbindung zwischen einer zugehenden und einer abgehenden Busleitung über dieses Anschlußmodul 44 schaffen zu können. Am Gehäuse 41 ist oberseitig ein Schnittstellenanschluß 48 herausgeführt, der innerhalb des Gehäuses 41 mit den Zwischenelementen 416 elektrisch verbunden ist. Weiterhin ist am Gehäuse 41 in einer Seitenfläche eine dritte Ausnehmung 413 mit buchsenartigen elektrischen Verbindungsmitteln 418 und auf der gegenüberliegenden Seitenfläche eine vorstehende Anformung 417 mit stiftartigen Verbindungsmitteln 419 vorgesehen. Gegenüberliegende Verbindungselemente 418, 419 sind innerhalb des Gehäuses 41 sowohl durchgehend als auch mit den Zwischenelementen 416 leitend verbunden. Die quaderförmige Anformung 417 und die stiftartigen Verbindungsmittel 419 entsprechen in ihren Abmessungen bzw. gegenseitigen Abständen genau der dritten Ausnehmung 413 und den buchsenartigen Verbindungsmitteln 418. Damit ist es möglich, daß mehrere derartige Koppeleinheiten 40 mit den darauf befestigten elektrischen Einrichtungen durch Zusammenbringen der elektrischen Verbindungsmittel 418, 419 an das Bussystem gekoppelt werden können.

## Patentansprüche

1. Busfähige elektrische Koppeleinheit mit einem Gehäuse, mindestens einem Busanschluß, einem Schnittstellenanschluß für eine mehrfache elektrische Schnittstelle für mehrere anzusteuernde und/oder ansteuernde elektrische Einrichtungen, insbesondere Schaltgeräte, einer zwischen Busanschluß und Schnittstellenanschluß angeordneten elektronischen Baugruppe zur Organisation des Datenaustausches zwischen dem Bus und den elektrischen Einrichtungen, und
unterschiedliche, austauschbare Verarbeitungsmodule (22, 23; 32; 42), die in das Gehäuse (21; 31; 41) unter Herstellung der elektrischen Verbindungen zu dem mindestens einen Busanschluß und dem Schnittstellenanschluß (218; 38; 48) einsetzbar sind und die elektronische Baugruppe (421) enthalten, die mit dem jeweiligen Bussystem kompatibel ist, **dadurch gekennzeichnet,**
- **daß** unterschiedliche, austauschbare Anschlußmodule (24, 25; 34; 44) vorgesehen sind, die in das Gehäuse (21; 31; 41) unter Herstellung der elektrischen Verbindungen zum Verarbeitungsmodul (22, 23; 32; 42) einsetzbar sind und den mit dem jeweiligen Bussystem kompatiblen mindestens einen Busanschluß enthalten.

2. Koppeleinheit nach vorstehendem Anspruch, **dadurch gekennzeichnet, daß** mindestens eines der Anschlußmodule (24, 25; 34; 44) für durchgehende Busleitungen ausgebildet ist.

3. Koppeleinheit nach einem der vorstehenden Ansprüche, **dadurch gekennzeichnet, daß** mindestens eines der Anschlußmodule (44) doppelt ausgeführt und elektrisch durchgehend verbunden ist.

4. Koppeleinheit nach einem der vorstehenden Ansprüche, **dadurch gekennzeichnet, daß** die Anschlußmodule (24, 25; 34; 44) hinsichtlich unterschiedlicher Versorgungspotentiale codiert sind.

5. Koppeleinheit nach einem der vorstehenden Ansprüche, **dadurch gekennzeichnet, daß** die elektronische Baugruppe (421) und trennbare elektrische Verbindungselemente (424) mit einem am Gehäuse (41) befestigbaren Träger (426) verbunden oder integriert sind.

6. Koppeleinheit nach Anspruch 5, **dadurch gekennzeichnet, daß** der Träger (426) über rastende Mittel mit dem Gehäuse (41) verbindbar ist.

7. Koppeleinheit nach einem der Ansprüche 5, oder 6, **dadurch gekennzeichnet, daß** der Träger (426) über Schraubverbindungsmittel mit dem Gehäuse (41) verbindbar ist.

8. Koppeleinheit nach einem der vorstehenden Ansprüche, **dadurch gekennzeichnet, daß** die Anschlußmodule (24; 25; 34; 44) über schnappende Mittel mit dem Gehäuse (21; 31; 41) verbindbar sind.

9. Koppeleinheit nach einem der vorstehenden Ansprüche, **dadurch gekennzeichnet, daß** die Anschlußmodule (24; 25; 34; 44) über Schraubverbindungsmittel mit dem Gehäuse (21; 31; 41) verbindbar sind.

10. Koppeleinheit nach einem der vorstehenden Ansprüche, **dadurch gekennzeichnet, daß** im Gehäuse (21; 31; 41) leitende Zwischenelemente (416) angeordnet sind, mit denen Verarbeitungsmodul (22; 23; 32; 42) und Busanschlüsse bzw. Anschlußmodule (24; 25; 34; 44) und/oder mit denen Verarbeitungsmodul (22; 23; 32; 42) und Schnittstellenanschluß (218; 38; 48) elektrisch verbindbar sind.

11. Koppeleinheit nach einem der vorstehenden Ansprüche, **dadurch gekennzeichnet, daß** sie zur Montage auf einer Montageplatte (82) für elektrische Einrichtungen ausgebildet ist und der Schnittstellenanschluß (218) mit einem Gegenanschluß (828) der Montageplatte (82) verbindbar ist.

12. Koppeleinheit nach einem der vorstehenden Ansprüche, **dadurch gekennzeichnet, daß** das Gehäuse (31; 41) Bestandteil einer Montageplatte für elektrische Einrichtungen (63) ist.

13. Koppeleinheit nach Anspruch 12, **dadurch gekennzeichnet, daß** am Gehäuse (41) elektrische Verbindungsmittel (418; 419) zur Herstellung einer durchgehenden Bus- und/oder Steuersignal- und/oder Versorgungspotentialverbindung zwischen zwei nebeneinander angeordneten derartigen Koppeleinheiten (40) vorgesehen sind.

14. Koppeleinheit nach einem der vorstehenden Ansprüche, **dadurch gekennzeichnet, daß** der Schnittstellenanschluß (38; 48) als eine Reihe von Anschlußklemmen (381) ausgebildet ist.

15. Koppeleinheit nach einem der vorstehenden Ansprüche, **dadurch gekennzeichnet, daß** weitere unterschiedliche, austauschbare Anschlußmodule vorgesehen sind, die in das Gehäuse unter Herstellung der elektrischen Verbindungen zum Verarbeitungsmodul in das Gehäuse einsetzbar sind und den mit den jeweiligen anzusteuernden und/oder ansteuernden elektrischen Einrichtungen kompatiblen Schnittstellenanschluß darstellen.

## Claims

1. Bus-compatible electrical coupling unit having an enclosure, at least one bus connection, an interface connection for a multiple electrical interface for two or more electrical devices which are to be driven and/or provide a drive, in particular switching devices, and an electronic assembly which is arranged between a bus connection and an interface connection for organization of the data interchange between the bus and the electrical devices, and different, interchangeable processing modules (22, 23; 32; 42) which can be inserted into the enclosure (21; 31; 41) to produce electrical connections to the at least one bus connection and the interface connection (218; 38; 48) and which contain the electronic assembly (421) which is compatible with the respective bus system, **characterized in that**
- different, interchangeable connection modules (24, 25; 34; 44) are provided, which can be inserted into the enclosure (21; 31; 41) to produce the electrical connections to the processing module (22, 23; 32; 42) and which contain at least one bus connection which is compatible with the respective bus system.

2. Coupling unit according to the preceding claim, **characterized in that** at least one of the connection modules (24, 25; 34; 44) is designed for continuous bus lines which pass through it.

3. Coupling unit according to one of the preceding claims, **characterized in that** at least one of the connection modules (44) is designed to be duplicated and is connected in an electrically continuous manner.

4. Coupling unit according to one of the preceding claims, **characterized in that** the connection modules (24, 25; 34; 44) are coded for different supply potentials.

5. Coupling unit according to one of the preceding claims, **characterized in that** the electronic assembly (421) and disconnectable electrical connecting elements (424) are connected to or integrated with a support (426) which can be mounted on the enclosure (41).

6. Coupling unit according to Claim 5, **characterized in that** the support (426) can be connected to the enclosure (41) via latching means.

7. Coupling unit according to one of Claims 5 or 6, **characterized in that** the support (426) can be connected to the enclosure (41) via screw connecting means.

8. Coupling unit according to one of the preceding claims, **characterized in that** the connection modules (24, 25; 34; 44) can be connected to the enclosure (21; 31; 41) via snap-action means.

9. Coupling unit according to one of the preceding claims, **characterized in that** the connection modules (24, 25; 34; 44) can be connected to the enclosure (21; 31; 41) via screw connecting means.

10. Coupling unit according to one of the preceding claims, **characterized in that** conductive intermediate elements (416) are arranged in the enclosure (21; 31; 41), to which a processing module (22; 23; 32; 42) and bus connections or connection modules (24, 25; 34; 44) can be electrically connected, and/or to which a processing module (22; 23; 32; 42) and an interface connection (218; 38; 48) can be electrically connected.

11. Coupling unit according to one of the preceding claims, **characterized in that** the coupling unit is designed for mounting on a mounting plate (82) for electrical devices, and the interface connection (218) can be connected to a mating connection (828) on the mounting plate (82).

12. Coupling unit according to one of the preceding claims, **characterized in that** the enclosure (31; 41) is a component of a mounting plate for electrical devices (63).

13. Coupling unit according to Claim 12, **characterized in that** electrical connecting means (418; 419) are provided on the enclosure (41), in order to produce a continuous bus connection and/or control signal connection and/or supply potential connection between two such coupling units (40) which are arranged alongside one another.

14. Coupling unit according to one of the preceding claims, **characterized in that** the interface connection (38; 48) is in the form of a row of connecting terminals (381).

15. Coupling unit according to one of the preceding claims, **characterized in that** further, different, interchangeable connection modules are provided, which can be inserted into the enclosure to produce the electrical connections to the processing module, and which represent the interface connection which is compatible with the respective electrical devices which are to be driven and/or provide a drive.

## Revendications

1. Unité de couplage électrique avec interface de bus comprenant un boîtier, au moins une borne de bus, une borne d'interface pour une interface électrique multiple pour plusieurs appareillages électriques à commander et/ou de commande, notamment des appareils de commutation, un sous-ensemble électronique disposé entre la borne de bus et la borne d'interface pour organiser l'échange de données entre le bus et les appareillages électriques et différents modules de traitement (22, 23 ; 32 ; 42) interchangeables qui peuvent être insérés dans le boîtier (21 ; 31 ; 41) en établissant les liaisons électriques avec l'au moins une borne de bus et la borne d'interface (218 ; 38 ; 48) et contiennent le sous-ensemble électronique (421) qui est compatible avec le système de bus correspondant, **caractérisée en ce que** sont prévus différents modules de raccordement (24, 25 ; 34 ; 44) interchangeables qui peuvent être insérés dans le boîtier (21 ; 31 ; 41) en établissant les liaisons électriques avec le module de traitement (22, 23 ; 32 ; 42) et contiennent l'au moins une borne de bus compatible avec le système de bus correspondant.

2. Unité de couplage selon la revendication précédente, **caractérisée en ce qu'**au moins l'un des modules de raccordement (24, 25 ; 34 ; 44) est configuré pour des lignes de bus de bout en bout.

3. Unité de couplage selon l'une des revendications précédentes, **caractérisée en ce qu'**au moins l'un des modules de raccordement (44) est doublé et relié électriquement de bout en bout.

4. Unité de couplage selon l'une des revendications précédentes, **caractérisée en ce que** les modules de raccordement (24, 25 ; 34 ; 44) sont codés du point de vue de différents potentiels d'alimentation.

5. Unité de couplage selon l'une des revendications précédentes, **caractérisée en ce que** le sous-ensemble électronique (421) et des éléments de liaison électrique séparables (424) sont reliés ou intégrés avec un support (426) qui peut être fixé au boîtier (41).

6. Unité de couplage selon la revendication 5, **caractérisée en ce que** le support (426) peut être relié au boîtier (41) par le biais de moyens encliquetables.

7. Unité de couplage selon l'une des revendications 5 ou 6, **caractérisée en ce que** le support (426) peut être relié au boîtier (41) par le biais de moyens de liaison à visser.

8. Unité de couplage selon l'une des revendications précédentes, **caractérisée en ce que** les modules de raccordement (24 ; 25 ; 34 ; 44) peuvent être reliés au boîtier (21 ; 31 ; 41) par le biais de moyens à enclenchement.

9. Unité de couplage selon l'une des revendications précédentes, **caractérisée en ce que** les modules de raccordement (24 ; 25 ; 34 ; 44) peuvent être reliés au boîtier (21 ; 31 ; 41) par le biais de moyens de liaison à visser.

10. Unité de couplage selon l'une des revendications précédentes, **caractérisée en ce que** dans le boîtier (21 ; 31 ; 41) sont disposés des éléments intermédiaires conducteurs (416) avec lesquels le module de traitement (22 ; 23 ; 32 ; 42) et les bornes de bus ou les modules de raccordement (24 ; 25 ; 34 ; 44) et/ou avec lesquels le module de traitement (22 ; 23 ; 32 ; 42) et la borne d'interface (218 ; 38 ; 48) peuvent être reliés électriquement.

11. Unité de couplage selon l'une des revendications précédentes, **caractérisée en ce qu'**elle est configurée pour être montée sur une plaque de montage (82) pour appareillages électriques et la borne d'interface (218) peut être reliée avec une borne homologue (828) de la plaque de montage (82).

12. Unité de couplage selon l'une des revendications précédentes, **caractérisée en ce que** le boîtier (31 ; 41) fait partie intégrante d'une plaque de montage pour appareillages électriques (63).

13. Unité de couplage selon la revendication 12, **caractérisée en ce que** des moyens de liaison électrique (418 ; 419) sont prévus sur le boîtier (41) pour établir une liaison de bout en bout du bus et/ou du signal de commande et/ou du potentiel d'alimentation entre deux unités de couplage (40) de ce type disposées l'une à côté de l'autre.

14. Unité de couplage selon l'une des revendications précédentes, **caractérisée en ce que** la borne d'interface (38 ; 48) est réalisée sous la forme d'une rangée de bornes de raccordement (381).

15. Unité de couplage selon l'une des revendications précédentes, **caractérisée en ce que** d'autres modules de raccordement interchangeables différents sont prévus, lesquels peuvent être insérés dans le boîtier en établissant les liaisons électriques avec le module de traitement et représentent la borne d'interface compatible avec les appareillages électriques respectifs à commander et/ou de commande.
